Europäisches Patentamt

European Patent Office

Office européen des brevets

(19)

(11) **EP 0 646 249 B1**

(12) **EUROPÄISCHE PATENTSCHRIFT**

(45) Veröffentlichungstag und Bekanntmachung des Hinweises auf die Patenterteilung:
**04.09.1996 Patentblatt 1996/36**

(51) Int Cl.6: **G01R 31/11**

(86) Internationale Anmeldenummer:
**PCT/DE93/00444**

(21) Anmeldenummer: **93909783.8**

(22) Anmeldetag: **17.05.1993**

(87) Internationale Veröffentlichungsnummer:
**WO 94/00772 (06.01.1994 Gazette 1994/02)**

(54) **VERFAHREN ZUM ERMITTELN VON ANOMALIEN EINER ZU UNTERSUCHENDEN LEITUNG**

PROCESS FOR DETECTING ABNORMALITIES IN A LINE TO BE EXAMINED

PROCEDE POUR LA DETERMINATION D'ANOMALIES DANS UNE LIGNE A EXAMINER

(84) Benannte Vertragsstaaten:
**DE FR GB**

(30) Priorität: **19.06.1992 DE 4220409**

(43) Veröffentlichungstag der Anmeldung:
**05.04.1995 Patentblatt 1995/14**

(73) Patentinhaber: **SIEMENS AKTIENGESELLSCHAFT**
**80333 München (DE)**

(72) Erfinder: **MEYER, Stephan**
**D-13353 Berlin (DE)**

(56) Entgegenhaltungen:
**DE-B- 1 233 488**

- **CABLES ET TRANSMISSION Bd. 29, Nr. 2, April 1975, PARIS FR Seiten 225 - 238; FENOUILLET ET AL. 'TRANSIMETRE POUR PAIRES COAXIALES...'**
- **IEEE INT. SYMP. ON EL.MAG. COMPATIBILITY 4. August 1988, SEATTLE, USA Seiten 1 - 5 KORTSTOCK 'POWER REFLECTION TECHNIQUES IN SUSCEPTIBILITY TESTS...'**
- **ISSLS, INTERNATIONAL SYMPOSIUM ON SUBSCRIBERS LOOPS AND SERVICES 5. Oktober 1984, NICE, Seiten 227 - 232; LASSAUX ET AL.: 'ECHOMETRE NUMERIQUE POUR LOCALISER LES DERANGEMENT ...'**

**Beschreibung**

Die Erfindung bezieht sich auf ein Verfahren zum Ermitteln von Anomalien einer zu untersuchenden Leitung, bei dem auf eine impulsförmige Signal-Beaufschlagung der Leitung an ihrem Ende hin ein in der Leitung reflektiertes Signal an demselben Ende der Leitung erfaßt wird.

Bei einem bekannten Verfahren dieser Art (EP-A-0 433 020) wird zur Verbesserung der Genauigkeit des Verfahrens, insbesondere zur Verminderung von Einflüssen des Rauschens, jeder Punkt des reflektierten Signals mehrmals abgetastet und ein Durchschnittswert gebildet. Um die zahl der dabei zu berücksichtigenden Abtastwerte unter Erhöhung der Meßgeschwindigkeit zu verringern, wird vor Beginn der Messung zum Beispiel an einer optischen Leitung einerseits das Systemrauschen und andererseits das optische Rauschen ermittelt; die dafür ermittelten Größen werden festgehalten. Danach wird bei der Durchführung des bekannten Verfahrens der jeweilige Abtastwert mehrmals hintereinander erfaßt, der Durchschmittswert gebildet und der Rauschanteil im Ergebnis errechnet. Stellt sich heraus, daß das Rauschen geringer ist als der dafür erwartete (vorher gemessene) Wert war, dann wird die Abtastung dieses Abtastwertes eingestellt und anhand von weiteren Auswertungen festgestellt, ob der ermittelte Meßwert den Rückschluß auf eine Anomalie in der zu untersuchenden optischen Leitung zuläßt.

Es ist ferner eine nach der Impulsreflexionsmethode arbeitende Anordnung zum Bestimmen von Fehleroder Inhomogenitatsstellen einer elektrischen Leitung bekannt (DE-B-12 33 488), bei der zur Erzielung exakter Meßergebnisse unter Berücksichtigung der frequenzabhängigen Dämpfungseigenschaften der jeweils zu untersuchenden elektrischen Leitung eine zweikanalige Verstärkerschaltung zur Entzerrung der reflektierten Impulse verwendet wird. Der Verstarkerschaltung ist über einen Differenzverstärker eine Brückenschaltung vorgeordnet, die in einem Brückenzweig die zu untersuchende elektrische Leitung und in einem weiteren Brückenzweig eine Leitungsnachbildung enthält; weitere Brükenzweige weisen ohmsche Widerstände auf. Durch die Brückenschaltung wird erreicht, daß bei einer Beaufschlagung der Eingangsdiagonale mit Prüfimpulsen an der Ausgangsdiagonale von dem Differenzverstärker nur die reflektierten Impulse erfaßt und zur entzerrenden Verstarkerschaltung weitergeleitet werden. Am Ausgang der verhältnismäßig aufwendig ausgebildeten Verstärkerschaltung entstehen Impulse, die einen zuverlässigen Rückschluß auf Größe und Entfernung eines Fehlers auf der untersuchten elektrischen Leitung zulassen.

Der Erfindung liegt die Aufgabe zugrunde, ein Verfahren zum Ermitteln von Anomalien in einer zu untersuchenden leitung vorzuschlagen, mit dem das Meßergebnis mit vergleichsweise geringen Zeitaufwand bei einer hohen

Genauigkeit erzielt werden kann.

Zur Lösung dieser Aufgabe wird bei einem Verfahren der eingangs angegebenen Art erfindungsgemäß eine Gewichtsfunktion mit einem zeitlichen Verlauf gebildet, der charakteristisch für das Verhalten einer zur jeweils zu untersuchenden Leitung typengleichen Leitung bei impulsförmiger Beaufschlagung ist, und es wird die jeweils zu untersuchende Leitung mit einem einzigen Impuls als impulsförmige Beaufschlagung beaufschlagt; anschließend wird das erfaßte reflektierte Signal im Rahmen einer Faltungsoperation mit der Gewichtsfunktion gewichtet.

Dabei wird unter einem "einzigen Impuls" im Rahmen der Erfindung auch eine Impulsfolge verstanden, die aus technischen Gründen im Rahmen eines sog. Multiperioden-Sampling benutzt wird, um in kürzesten zeitlichen Abständen aufeinanderfolgende Abtastwerte zu erfassen.

Der wesentliche Vorteil des erfindungsgemäßen Verfahrens besteht darin, daß zum Ermitteln von Anomalien einer zu untersuchenden Leitung die Leitung nur mit einem einzigen Impuls beaufschlagt bzw. nur eine Reihe von Abtastwerten aufgenommen werden muß. Dadurch, daß nämlich - zur Untersuchung von Leitungen desselben Typs - einmal eine Gewichtsfunktion mit einem zeitlichen Verlauf gebildet wird, der charakteristisch für das Verhalten einer Leitung solchen Typs bei impulsförmiger Beaufschlagung ist, läßt sich allein durch das auf einen Sendeimpuls hin erfaßte reflektierte Signal im Rahmen einer Faltungsoperation mit der Gewichtsfunktion eine Gewichtung vornehmen, die ein genaues Ermitteln von ggf. vorhandenen Anomalien gestattet. Es ist zwar bei dem erfindungsgemäßen Verfahren vor Beginn der Messung an einer zu untersuchenden Leitung die Gewichtsfunktion an einer Leitung gleichen Typs festzustellen und festzuhalten, jedoch ist diese Feststellung für alle später zu untersuchenden Leitungen des gleichen Typs nur dieses einzige Mal erforderlich. Nach dieser Vorarbeit kann dann das erfindungsgemäße Verfahren vergleichsweise schnell mit hoher Genauigkeit durchgeführt werden.

Der Gewichtsfunktion kommt bei der Durchführung des erfindungsgemäßen Verfahrens eine große Bedeutung bei, bestimmt sie doch die Genauigkeit beim Ermitteln von Anomalien auf der zu untersuchenden Leitung. Als vorteilhaft hat es sich im Rahmen der Durchführung des erfindungsgemäßen Verfahrens erwiesen, wenn die Gewichtsfunktion unter Berücksichtigung der verschiedenen Anstiegszeiten von erfaßten reflektierten Impulsen gebildet wird, die aufgrund von an unterschiedlichen Stellen befindlichen Anomalien auf der typengleichen Leitung entstanden sind. Es hat sich nämlich gezeigt, daß die Impulsantwort einer fehlabgeschlossenen Leitung abhängig von der Entfernung des Fehlabschlusses von dem Ende der Leitung ist, an dem die Signal-Beaufschlagung erfolgt. Die Entfernung des Fehlabschlusses ist proportional zur Aufnahmezeit, d. h. der Zeit, die jeweils vom Zeitpunkt der Signal-Beaufschlagung bis zur Aufnahme des reflektierten Signals verstrichen ist. Es kann daher von einem nichtstationären Verhalten ausgegangen werden. Das Frequenzspektrum möglicher Impulsantworten wird mit zunehmender Zeit eingeschränkt. Dies bedeutet, daß sich die Entfernung eines Fehlabschlusses auf einer zu untersuchenden Leitung in der unterschiedlichen Anstiegszeit der Impulsantwort ausdrückt. Die Anstiegszeit eines erfaßten reflektierten Impulses wird somit mit wachsender Länge immer größer, sie beträgt z.B. bei einer symmetrischen Leitung von 20 Meter Länge (Fehlabschluß bei 20 m) beispielsweise etwa 16 ns und bei 100 Meter Länge ca. 60 ns. Wird dementsprechend die Gewichtsfunktion unter Berücksichtigung der verschiedenen Anstiegszeiten gebildet, dann läßt sich durch eine Faltungsoperation des erfaßten reflektierten Signals mit der Gewichtsfunktion ein Verlauf des gewichteten reflektierten Signals über der Zeit gewinnen, der genaue Aussagen über das Vorhandensein von Anomalien auf einer zu untersuchenden Leitung gestattet.

Im Rahmen des erfindungsgemäßen Verfahrens kann die Gewichtsfunktion in vorteilhafter Weise auch unter Berücksichtigung der verschiedenen Spitzenwerte von erfaßten reflektierten Impulsen gebildet werden, die aufgrund von an unterschiedlichen Stellen befindlichen Anomalien auf der typengleichen Leitung entstanden sind. Dies beruht darauf, daß mit wachsender Entfernung eines Fehlabschlusses von dem impulsbeaufschlagten Ende der zu untersuchenden Leitung auch die Spitzenwerte der erfaßten reflektierten Impulse abnehmen.

Um das erfindungsgemäße Verfahren mit möglichst geringem Aufwand und besonders schnell durchführen zu können, wird es als vorteilhaft angesehen, wenn das reflektierte Signal abgetastet wird und die dabei gewonnenen Abtastwerte unter Festhalten ihres Zeitranges gespeichert werden; es wird eine Gewichtsfunktion verwendet, die eine konstante oder unterschiedliche Wichtung der Abtastwerte über eine unterschiedliche Anzahl jeweils zeitlich aufeinander folgender Abtastwerte bewirkt. Bei einer Art des erfindungsgemäßen Verfahrens mit konstanter Wichtung werden vorteilhafterweise gewichtete Abtastwerte $Y_i$ entsprechend der Beziehung

$$Y_i = \frac{1}{N_{max}} \cdot \sum x\,(i\text{-}n)$$

mit

$$n = 1 \ldots N_{max}$$

und

$$N_{max} = tr$$

gebildet, wobei $N_{max}$ die Anzahl der zur jeweiligen Mittelwertbildung herangezogenen Abtastwerte, n einen Laufindex und x(i-n) die jeweils berücksichtigten, ungewichteten Abtastwerte und tr die Anstiegszeit bezeichnen.

Bei einem Verfahren mit unterschiedlicher Wichtung kann die Wichtung z. B. entsprechend der Gewichtsfunktion eines RC-Gliedes erfolgen.

Anstelle der oben behandelten digitalen Filterung (Wichtung) kann im Rahmen des erfindungsgemäßen Verfahrens die Wichtung des erfaßten reflektierten Signals auch mittels eines Analog-Filters vorgenommen werden, dem eingangsseitig das Signal zugeführt wird. Vorteile sind die vergleichsweise große Schnelligkeit und die große Bandbreite.

Zur Erläuterung der Erfindung sind in

Figur 1    ein Blockschaltbild einer Anordnung zur Durchführung des erfindungsgemäßen Verfahrens, in

Figur 2    eine vorteilhafte Gewichtsfunktion für die Durchführung des erfindungsgemäßen Verfahrens, in

Figur 3    unterschiedliche reflektierte Signale, in

Figur 4    drei Diagramme zur Veranschaulichung der mit dem erfindungsgemäßen Verfahren erzielten Rauschunterdrückung, in

Figur 5    Leitungsimpulsantworten in dreidimensionaler Darstellung und in

Figur 6    ein Diagramm zur Darstellung der Abhängigkeit der Anstieg von Leitungsimpulsantworten von der Leitungslänge wiedergegeben.

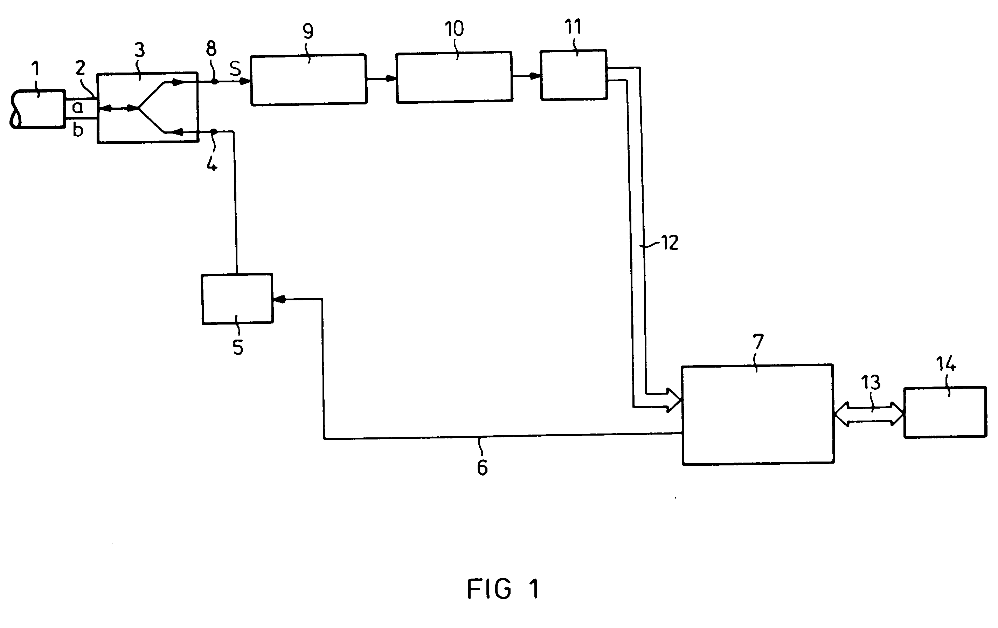

Bei der in Figur 1 dargestellten Anordnung zur Durchführung des erfindungsgemäßen Verfahrens handelt es sich um eine Anordnung, mit der Anomalien auf einer symmetrischen Leitung 1 ermittelt werden können, die mit einem Ende 2 über einen Koppler 3 angeschlossen ist. Dem Koppler 3 wird über einen Eingang 4 ein Impuls eines Pulsgenerators 5 zugeführt, der über eine Leitung 6 mit einem Trigger-Impuls aus einer Steuereinrichtung 7 beaufschlagt ist. Das von der zu untersuchenden Leitung 1 reflektierte Signal S wird über einen Ausgang 8 und einen nachgeordneten Verstärker 9 einer Abtasteinrichtung 10 zugeführt, der ein Analog-Digital-Umsetzer 11 nachgeordnet ist. Dieser Umsetzer 11 ist über einen Datenbus 12 mit der Steuereinrichtung 7 verbunden. In der Steuereinrichtung 7, vorzugsweise ein elektronischer Rechner, werden die Abtastwerte gespeichert. Der Steuereinrichtung 7 ist über einen weiteren Datenbus 13 eine Anzeigevorrichtung 14 nachgeordnet.

Bei einer nicht dargesellten Variante der Anordnung nach Figur 1 ist zwischen dem Verstärker 9 und der Abtasteinrichtung 10 ein Analog-Filter geschaltet, das eine Wichtung des Signals S entsprechend der leitungsspezifischen Wichtungsfunktion vornimmt. Dieser Analog-Filter kann beispielsweise ein RC-Glied mit steuerbarer Grenzfrequenz sein. An diesen Filter kann ausgangsseitig unmittelbar eine analoge Anzeigeeinheit angeschlossen werden.

Bei der Durchführung des erfindungsgemäßen Verfahrens mit Berücksichtigung der Anstiegszeiten von Leitungsimpulsantworten einer zur untersuchenden symmetrischen Leitung 1 typengleichen Leitung wird zunächst jeweils die Anstiegszeit tr von in einer solchen typengleichen Leitung reflektierten Impulsen in Abhängigkeit von der Entfernung des angenommenen Fehlabschlusses nach der folgenden allgemeinen Beziehung (1) errechnet

$$tr = a_{tr} L^b tr \qquad (1)$$

In dieser Gleichung (1) gibt L die Entfernung der Anomalie bzw. des Fehlers von dem einen Ende 2a der Leitung 1 in Metern an; die Größen $a_{tr}$ und $b_{tr}$ kennzeichnen leitungsspezifische Koeffizienten. Bei einer bestimmten symmetrischen Leitung 1 (z.B. J-Y(St)Y 2 x 2 x 0.6) lassen sich die Anstiegszeiten tr nach folgender Gleichung (2) ermitteln

$$tr = 0.31 \, L^{1.12} \qquad (2)$$

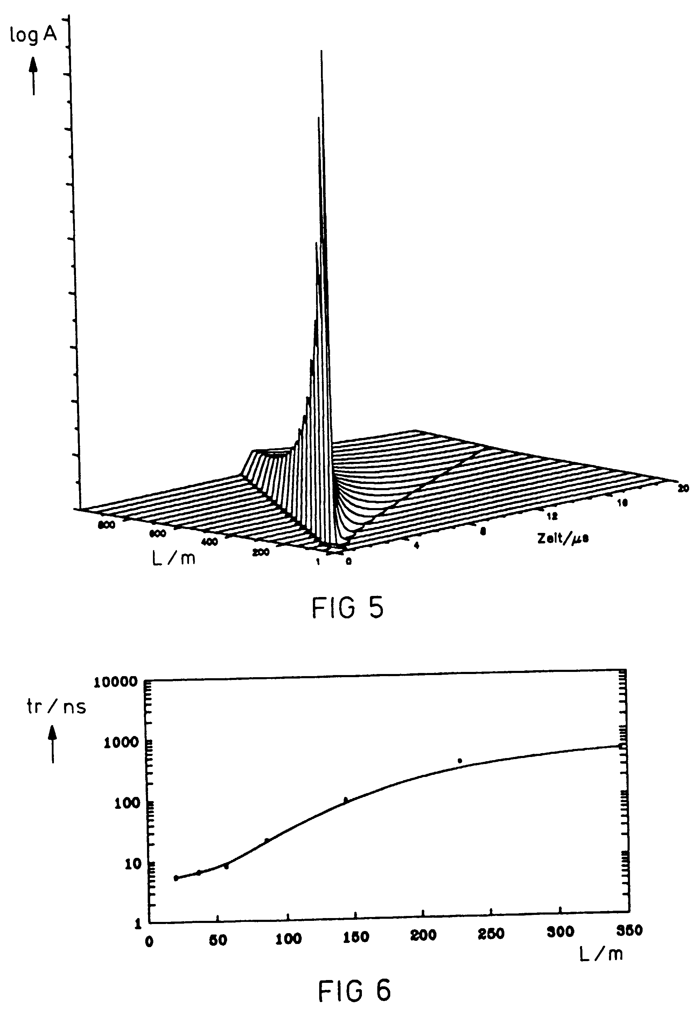

Für die hier betrachtete symmetrische Leitung als zu untersuchender Leitung 1 ergibt sich ein Verlauf der Anstiegszeiten tr der Leitungsimpulsantworten gemäß dem Diagramm nach Fig. 6, in dem über der Länge L einer typengleichen Leitung in Metern die Anstiegszeiten tr von Leitungsimpulsantworten in ns aufgetragen sind.

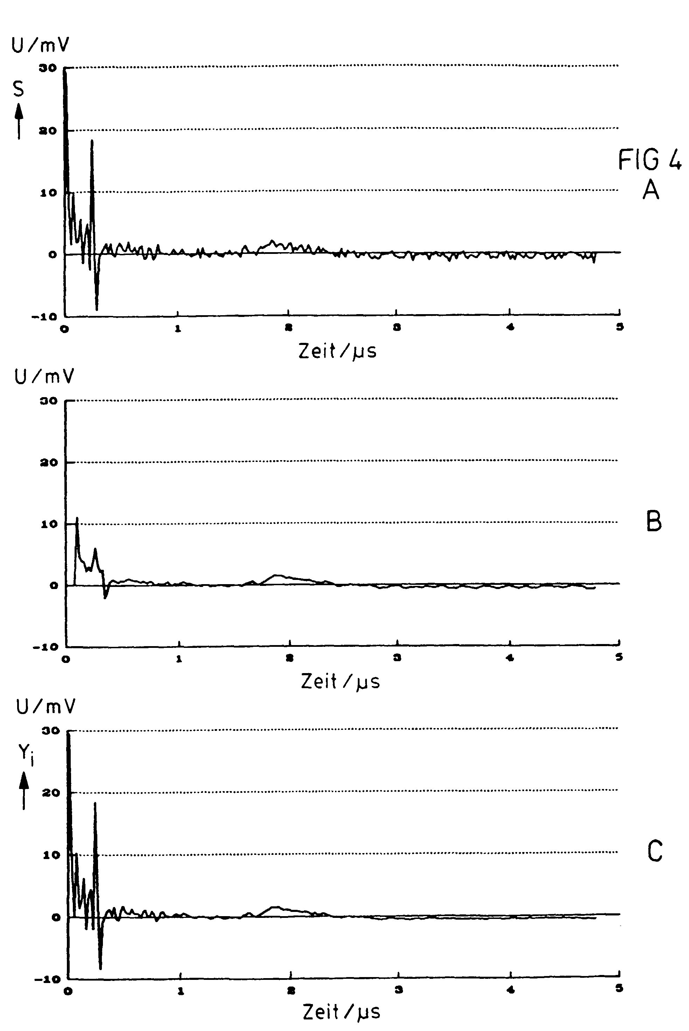

In Figur 3 sind zur Veranschaulichung des Reflexionsverhaltens der zu untersuchenden Leitung 1 bzw. einer dazu typengleichen Leitung Impulsantworten (reflektiertes Signal S) von unterschiedlich langen Leitungen gezeigt (jeweils der Wert in mV über der Zeit in ns). Das linke Diagramm der Figur 3 zeigt die Impulsantwort bei einer bei 20 m Länge offenen Leitung (Anomalie also bei 20 m), während das rechte Diagramm die Impulsantwort bei einer Anomalie in 60 m Entfernung vom Einspeiseende wiedergibt.

Insgesamt ergeben sich Impulsantworten, wie sie in Figur 5 dreidimensional dargestellt sind. Sie stellt die Eintreffzeit (linear zur Länge), Impulsdauer und Amplitude A der Leitungsimpulsantworten als Funktion der Länge dar. Für kurze Längen ist die Antwort noch einem Dirac-Impuls ähnlich. Sie verbreitert sich aber wegen der Dispersion vor allem im abfallenden Bereich der Impulsantwort sehr stark mit wachsender Länge. Die Bandbreitenbegrenzung der Antwort, bedingt durch den Tiefpaßcharakter der Leitung, führt zu einem immer länger andauernden Anstieg. Das Maximum wird im Vergleich zum Pulsanfang immer später erreicht.

Bei dem erfindungsgemäßen Verfahren der hier beschriebenen Art wird jeder gespeicherte Abtastwert durch Gewichtung in einen gewichteten Absatzwert $Y_i$ nach folgender Beziehung (3) umgerechnet:

$$Y_i = \frac{1}{N_{max}} \cdot \sum X \, (i\text{-}n) \qquad (3)$$

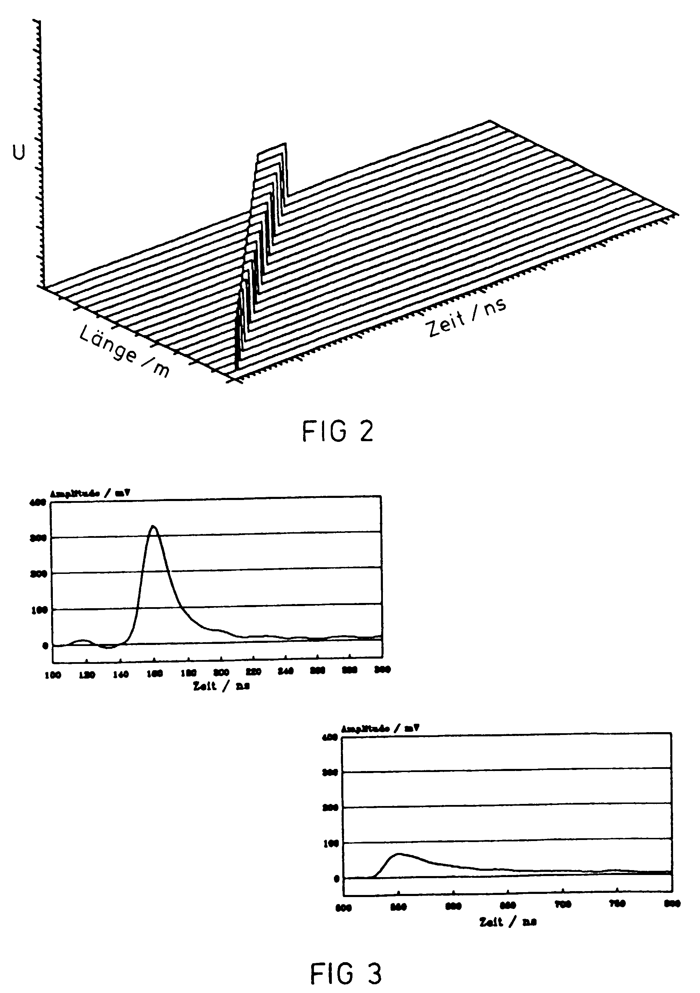

in der n = 1 ... $N_{max}$ und $N_{max} = t_r$ ist; n bezeichnet einen Laufindex, während i einen beliebigen Abtastpunkt der auf der Leitung 1 reflektierten Impulse (Impulsantwort) angibt. Gleichung (3) besagt demzufolge, daß ein beliebiger Abtastwert dadurch gewichtet wird, daß die durch n = 1 ... $N_{max}$ bezeichneten, dem Abtastzeitpunkt i vorangegangenen (gespeicherten) Abtastwerte addiert werden und durch $N_{max}$ dividiert werden, was eine Mittelwertbildung darstellt. $N_{max}$ entspricht dabei der Anstiegszeit tr (nach Gleichung (1) ermittelbar) zum Zeitpunkt i nach der Impulsbeaufschlagung der zur untersuchenden Leitung 1. Es ist somit eine Gewichtsfunktion erzeugt, wie sie als Funktion der Länge der zu untersuchenden Leitung 1 und der Zeit in Fig. 2 dargestellt ist. Es ist deutlich zu erkennen, daß mit wachsender Entfernung des Fehlabschlusses vom Einspeisepunkt bzw. mit zunehmender Zeit die Gewichtsfunktion einen immer breiteren Bereich der Meßreihe wichtet. Die jeweils so gewonnenen gewichteten Abtastwerte $Y_i$ sind in dem Diagramm C der Figur 4 über der Zeit aufgeführt.

Berücksichtigt man, daß sich ohne jede Gewichtung der Abtastwerte des von der zu untersuchenden Leitung 1 reflektierten Signals S ein Verlauf entsprechend dem Diagramm A der Figur 2 ergeben würde, dann ist deutlich zu erkennen, daß mit dem erfindungsgemäßen Verfahren durch die gute Rauschunterdrükkung im Fernbereich schwache Signale wesentlich besser detektiert werden. Dies gilt auch im Vergleich zu dem Kurvenverlauf nach Diagramm B der Figur 2, wo eine Filterung mit einem normalen Tiefpaßfilter erfolgt ist.

Bei der Durchführung des erfindungsgemäßen Verfahrens mit der Anordnung nach Figur 1 ist die Gewichtsfunktion in der Steuereinrichtung 7 gespeichert. Auch die Faltungsoperationen erfolgen in dem Rechner 7, so daß auf der nachgeordneten Anzeigevorrichtung 24 die gewichteten Abtastwerte $Y_i$ gemäß Diagramm C der Figur 4 angezeigt werden. Dem angezeigten Kurvenlauf sind die Anomalien der untersuchten Leitung 1 entnehmbar.

## Patentansprüche

1. Verfahren zum Ermitteln von Anomalien einer zu untersuchenden Leitung, bei dem

   - auf eine impulsförmige Signal-Beaufschlagung der Leitung an ihrem einen Ende hin ein in der Leitung reflektiertes Signal an demselben Ende der Leitung erfaßt wird,

   **dadurch gekennzeichnet**, daß

   - eine Gewichtsfunktion mit einem zeitlichen Verlauf gebildet wird, der charakteristisch für das Verhalten einer zur jeweils zu untersuchenden Leitung (1) typengleichen Leitung bei impulsförmiger Beaufschlagung ist,
   - die jeweils zu untersuchende Leitung (1) mit einem einzigen Impuls als impulsförmige Beaufschlagung beaufschlagt wird und

- das erfaßte reflektierte Signal (S) im Rahmen einer Faltungsoperation mit der Gewichtsfunktion gewichtet wird.

2. Verfahren nach Anspruch 1,
**dadurch gekennzeichnet**, daß

- die Gewichtsfunktion unter Berücksichtigung der verschiedenen Anstiegszeiten (tr) von erfaßten reflektierten Impulsen (S) gebildet wird, die aufgrund von an unterschiedlichen Stellen befindlichen Anomalien der typengleichen Leitung entstanden sind.

3. Verfahren nach Anspruch 1 oder 2,
**dadurch gekennzeichnet**, daß

- die Gewichtsfunktion unter Berücksichtigung der verschiedenen Spitzenwerte von erfaßten reflektierten Impulsen gebildet wird, die aufgrund von an unterschiedlichen Stellen befindlichen Anomalien der typengleichen Leitung entstanden sind.

4. Verfahren nach einem der vorangehenden Ansprüche,
**dadurch gekennzeichnet**, daß

- das reflektierte Signal (S) abgetastet wird und die dabei gewonnenen Abtastwerte unter Festhalten ihres Zeitranges gespeichert werden und
- eine Gewichtsfunktion verwendet wird, die eine konstante oder unterschiedliche Wichtung der Abtastwerte über eine unterschiedliche Anzahl jeweils zeitlich aufeinander folgender Abtastwerte bewirkt.

5. Verfahren nach Anspruch 4,
**dadurch gekennzeichnet**, daß

- gewichtete Abtastwerte $Y_i$ in Form jeweils einer Mittelwertbildung entsprechend der Beziehung

$$Y_i = \frac{1}{N_{max}} \cdot \sum x\,(i\text{-}n)$$

mit

$$n = 1 \ldots N_{max}$$

und

$$N_{max} = tr$$

gebildet werden, wobei $N_{max}$ die Anzahl der zur jeweiligen Mittelwertbildung herangezogenen Abtastwerte, n einen Laufindex, x(i-n) die jeweils berücksichtigten, ungewichteten Abtastwerte und tr die Anstiegszeit bezeichnen.

6. Verfahren nach einem der Ansprüche 1 bis 3,
**dadurch gekennzeichnet**, daß

- die Wichtung des erfaßten reflektierten Signals mittels eines Analog-Filters vorgenommen wird, dem eingangsseitig das Signal zugeführt wird.

**Claims**

1. Method for determining anomalies of a line which is to be examined, wherein

- in response to application of pulse signals to the line at its one end a signal which is reflected in the line is detected at the same end of the line,

characterised in that

- a weighting function is formed that has a time characteristic which is typical of the behaviour of a line, which is of the same type as the respective line (1) to be examined, when pulses are applied thereto,
- a single pulse, as the pulse-application, is applied to the respective line (1) to be examined, and
- the detected reflected signal (S) is weighted within the framework of a convolution operation with the weighting function.

2. Method according to claim 1, characterised in that

- the weighting function is formed in consideration of the various rise times (tr) of detected reflected pulses (S) which have emerged on account of anomalies, which are found at different points, of the line which is of the same type.

3. Method according to claim 1 or 2, characterised in that

- the weighting function is formed in consideration of the various peak values of detected reflected pulses which have emerged on account of anomalies, which are found at different points, of the line which is of the same type.

4. Method according to one of the preceding claims, characterised in that

- the reflected signal (S) is scanned and the scan values thereby obtained are stored whilst retaining their order in time, and
- a weighting function is used that effects a constant or different weighting of the scan values by means of a different number of, in each case, temporally successive scan values.

5. Method according to claim 4, characterised in that

- weighted scan values $Y_i$ are formed in the manner of a respective mean-value generation in accordance with the relationship

$$Y_i = \frac{1}{N_{max}} \cdot \sum x\,(i\text{-}n)$$

with

$$n=1...N_{max}$$

and

$$N_{max}=tr'$$

where $N_{max}$ denotes the number of scan values which are used to establish the respective mean value, n denotes a run index, x(i-n) denotes the unweighted scan values which are considered in each case and tr denotes the rise time.

6. Method according to one of the claims 1 to 3, characterised in that

- the weighting of the detected reflected signal is effected by means of an analog-filter, to which the signal is supplied on the input side.

## Revendications

1. Procédé de détermination d'anomalies d'une ligne à examiner, dans lequel

- on détecte, après avoir appliqué un signal impulsionnel à l'une des extrémités de la ligne, à la même extrémité de la ligne, un signal réfléchi dans la ligne,

caractérisé en ce que

- on forme une fonction de pondération ayant une courbe temporelle, qui est caractéristique du comportement d'une ligne du même type que la ligne (1) à examiner lorsqu'on lui applique un signal impulsionnel,
- on applique à la ligne (1) à examiner une unique impulsion en tant qu'application d'un signal impulsionnel, et
- on pondère le signal (S) réfléchi et détecté par la fonction de pondération au cours d'une opération de convolution.

2. Procédé suivant la revendication 1, caractérisé en ce que

- on forme la fonction de pondération en tenant compte des divers temps (tr) de montée d'impulsions (S) réfléchies et détectées, qui sont apparues du fait d'anomalies se trouvant à des endroits différents de la ligne de même type.

3. Procédé suivant la revendication 1 ou 2, caractérisé en ce que

- on forme la fonction de pondération en tenant compte des diverses valeurs de crête d'impulsions réfléchies et détectées, qui sont apparues du fait d'anomalies se trouvant en des endroits différents de la ligne de même type.

4. Procédé suivant l'une des revendications précédentes, caractérisé en ce que

- on échantillonne le signal réfléchi (S) et on mémorise les valeurs d'échantillonnage ainsi obtenues en maintenant leur rang dans le temps, et
- on utilise une fonction de pondération, qui provoque une pondération, constante ou différente, des valeurs d'échantillonnage sur un nombre différent de valeurs d'échantillonnage se suivant dans le temps.

5. Procédé suivant la revendication 4, caractérisé en ce que

- on forme des valeurs $Y_i$ d'échantillonnage pondérées en formant une valeur moyenne suivant la relation

$$Y_i = \frac{1}{N_{max}} \cdot \sum x\,(i\text{-}n)$$

avec

$$n=1...N_{max}$$

et

$$N_{max}=tr$$

$N_{max}$ désignant le nombre des valeurs d'échantillonnage utilisées pour former la valeur moyenne, N étant un index courant, x(i-n) désignant les valeurs d'échantillonnage non pondérées considérées et tr désignant le temps de montée.

6. Procédé suivant l'une des revendications 1 à 3, caractérisé en ce que

- on procède à la pondération du signal réfléchi et détecté au moyen d'un filtre analogique, auquel on envoie en entrée le signal.

FIG 1

FIG 2

FIG 3

FIG 4

FIG 5

FIG 6